Europäisches Patentamt

**European Patent Office**

Office européen des brevets

(19)

(11) Numéro de publication: **0 265 319 B1**

(12) **FASCICULE DE BREVET EUROPEEN**

(45) Date de publication du fascicule du brevet:
25.07.90

(51) Int. Cl.⁵: **C30B 7/00, C30B 29/58**

(21) Numéro de dépôt: 87402239.5

(22) Date de dépôt: 08.10.87

(54) **Procédé, cellule et dispositif de cristallogénèse, notamment par vaisseau spatial.**

(30) Priorité: 09.10.86 FR 8614056

(43) Date de publication de la demande:
27.04.88 Bulletin 88/17

(45) Mention de la délivrance du brevet:
25.07.90 Bulletin 90/30

(84) Etats contractants désignés:
DE GB IT

(56) Documents cités:
US-A-3 788 818

JOURNAL OF CRYSTAL GROWTH,
vol. 76, no. 3, 11 août 1986, pages 663-672, Elsevier
Science Publishers B.V., (North-Holland, Physics
Publishing Division), Amsterdam, NL; W. LITTKE et al.:
"Protein single crystal growth under microgravity"

(73) Titulaire: AEROSPATIALE SOCIETE NATIONALE
INDUSTRIELLE Société Anonyme dite:, 37, Boulevard
de Montmorency, F-75016 Paris(FR)

(72) Inventeur: Claramonte, Manuel Pierre, 24, rue du
Coteau, F-92370 Chaville(FR)
Inventeur: Bonnet, Guy Michel, 98, rue de la Bruyère,
F-78300 Poissy(FR)
Inventeur: Auffret, Jean-Claude, 39, rue du Bout Malo,
F-78130 Chapet(FR)

(74) Mandataire: Bonnetat, Christian et al, CABINET
BONNETAT 23, Rue de Léningrad, F-75008 Paris(FR)

## Description

La présente invention concerne un procédé, une cellule et un dispositif de cristallogénèse, spécialement destinés à être mis en oeuvre à bord d'un vaisseau spatial.

On sait que l'une des méthodes d'étude des substances macromoléculaires consiste à former des cristaux desdites substances et à soumettre lesdits cristaux à des examens, notamment spectrographiques. Pour former de tels cristaux, on utilise entre autres des méthodes de diffusion à travers une paroi poreuse de diffusion. A cet effet, dans une enceinte, on dispose un creuset dont l'ouverture est recouverte de ladite paroi et qui est rempli d'un mélange liquide d'une substance macromoléculaire à étudier et d'un agent précipitant en concentration insuffisante pour agir, puis on introduit dans ladite enceinte un tel agent précipitant, soit sous forme vapeur (la paroi poreuse peut alors n'être qu'un filet), soit sous forme liquide (il s'agit alors de dialyse et la paroi poreuse est une membrane).

Par diffusion à travers ladite paroi poreuse, la concentration de l'agent précipitant mélangé à la substance macromoléculaire tend à s'aligner sur celle de l'agent précipitant contenu dans l'enceinte. Par suite, en faisant varier la concentration de ce dernier agent précipitant, on peut agir sur la cristallisation de ladite substance macromoléculaire. Généralement, le creuset et l'enceinte sont au moins partiellement transparents, de sorte qu'un opérateur peut suivre visuellement le développement de la cristallisation.

Toutefois, les cristaux obtenus dans les laboratoires terrestres par la mise en oeuvre de ces techniques de diffusion ne sont par parfaits, tant en qualité qu'en taille, notamment à cause des phénomènes de convexion dus à la pesanteur.

Pour remédier à cet inconvénient, il serait avantageux de pouvoir mettre en oeuvre de telles techniques de diffusion à bord de vaisseaux spatiaux, car alors les conditions d'apesanteur éliminent ces phénomènes de convexion. Cependant, une tentative pour mettre en oeuvre telles quelles les méthodes terrestres se heurterait à des difficultés, sinon des impossibilités, dues notamment aux conditions de lancement de vaisseaux spatiaux et à la faible durée de vie de certaines substances macromoléculaires (une quinzaine de jours pour les protéines par exemple). Par exemple, compte tenu des impératifs et des délais de préparation relativement longs du lancement d'un vaisseau spatial, les substances macromoléculaires seraient mortes avant que la cristallisation dans l'espace puisse être tentée.

La présente invention a pour objet principal un procédé, des cellules et un dispositif de cristallogénèse permettant d'adapter la méthode de diffusion à une utilisation à bord d'un vaisseau spatial.

A cette fin, selon l'invention, le procédé de cristallogénèse par diffusion, notamment destiné à être mis en oeuvre à bord d'un vaisseau spatial et selon lequel une substance à cristalliser contenue dans un creuset est mise en présence d'un agent précipitant à travers une paroi de diffusion obturant ledit creuset, est caractérisé:

– en ce que, dans un premier récipient, on agence ledit creuset contenant la substance à cristalliser et obturé par ladite paroi de diffusion;

– en ce que l'on obture ledit premier récipient par un bouchon de matière poreuse, susceptible d'être protégé par un premier capuchon d'obturation dudit premier récipient;

– en ce que, dans un second récipient, on agence un corps poreux, susceptible d'être protégé par un second capuchon d'obturation dudit second récipient, ce dernier étant en liaison avec des moyens d'injection d'agent précipitant;

– en ce que, lesdits premier et second capuchons étant ôtés, on rapproche lesdits premier et second récipients de façon que ledit corps poreux et ledit bouchon de matière poreuse soient au contact l'un de l'autre; et

– en ce que l'on injecte l'agent précipitant dans ledit corps poreux dudit second récipient, ledit agent précipitant diffusant à travers ledit corps poreux jusqu'à ladite paroi de diffusion.

On voit que, grâce à l'invention, ledit premier récipient peut être indépendant dudit second récipient, et peut être mis à bord du vaisseau spatial au dernier moment avant le lancement de celui-ci. On remarquera de plus que, après rapprochement desdits premier et second récipients, l'agent précipitant, avant d'atteindre la paroi de diffusion du creuset, doit traverser le corps poreux dudit second récipient et le bouchon de matière poreuse dudit premier récipient. Par suite, on bénéficie d'un large front de diffusion favorisant l'homogénéité du mélange et engendrant donc de bonnes conditions pour la formation des cristaux.

Le procédé selon l'invention peut être mis en oeuvre par diffusion en phase vapeur. Dans ce cas, avant injection dudit agent précipitant, l'espace intérieur dudit premier récipient est simplement rempli d'une ambiance gazeuse, neutre du point de vue de la cristallisation.

Toutefois, le procédé conforme à l'invention peut être mis en oeuvre selon le mode dialyse. Alors, avant injection dudit agent précipitant, l'espace intérieur dudit premier récipient est complètement rempli d'agent précipitant à une concentration insuffisante pour engendrer la cristallisation de ladite substance du creuset, et ledit corps poreux dudit second récipient est imbibé d'agent précipitant, également à une concentration insuffisante pour engendrer la cristallisation de ladite substance.

Notamment dans ce dernier cas, afin d'éviter d'emprisonner de l'air entre ledit bouchon de matière poreuse et ledit corps su moment de leur mise en contact, il est avantageux que au moins ledit corps poreux soit spongieux pour être comprimé dès son entrée en contact avec ledit bouchon de matière poreuse.

Par ailleurs, afin de donner plus de souplesse aux expériences de cristallisation, il est préférable que l'on puisse injecter dans ledit corps des concentrations différentes d'agent précipitant.

La présente invention concerne de plus une cellule de cristallogénèse par diffusion, comportant un creuset dans lequel est contenue une substance à cristalliser et qui est obturé par une paroi de diffusion, ledit creuset étant disposé dans une enceinte susceptible de contenir un agent précipitant. Selon l'invention, cette cellule est caractérisée en ce qu'elle comporte:

– un premier récipient dans lequel est agencé ledit creuset et qui est obturé par un bouchon de matière poreuse, susceptible d'être protégé par un premier capuchon d'obturation dudit premier récipient; et

– un second récipient ouvert contenant un corps poreux susceptible d'être protégé par un second capuchon d'obturation dudit second récipient et pourvu de moyens d'amenée d'agent précipitant, disposés du côté opposé à l'ouverture dudit second récipient par rapport audit corps poreux.

De préférence, ledit premier récipient peut s'emboîter de façon étanche dans ledit second récipient.

Dans un mode de réalisation avantageux, la face extérieure dudit corps poreux fait saillie à l'extérieur dudit second récipient, ledit corps poreux étant spongieux.

Dans ce cas, il est alors préférable que la partie saillante dudit corps poreux spongieux soit entourée par une bague coulissant à l'intérieur dudit second récipient. Ainsi, lors de l'accostage des premier et second récipient, ladite bague est repoussée vers l'intérieur dudit second récipient.

Grâce à la présente invention, on peut donc réaliser une installation de cristallogénèse, comportant au moins une cellule du type spécifié ci-dessus et caractérisée en ce qu'elle comporte:

- en ce que, dans un premier récipient, on agence ledit creuset contenant la substance à cristalliser et obturé par ladite paroi ;

- en ce que l'on obture ledit premier récipient par un bouchon de matière poreuse ;

- en ce que, dans un second récipient, on agence un corps poreux ;

- en ce que l'on rapproche lesdits premier et second récipients de façon que ledit corps poreux et ledit bouchon de matière poreuse soient au contact l'un de l'autre ; et

- en ce que l'on injecte ledit agent précipitant dans ledit corps poreux dudit second récipient.

On voit que, grâce à l'invention, ledit premier récipient peut être indépendant dudit second récipient, et peut être mis à bord du vaisseau spatial au dernier moment avant le lancement de celui-ci. On remarquera de plus que, après rapprochement desdits premier et second récipients, l'agent précipitant, avant d'atteindre la paroi de diffusion du creuset, doit traverser le corps poreux dudit second récipient et le bouchon de matière poreuse dudit premier récipient. Par suite, on bénéficie d'un large front de diffusion favorisant l'homogénéité du mélange et engendrant donc de bonnes conditions pour la formation des cristaux.

Le procédé selon l'invention peut être mis en oeuvre par diffusion en phase vapeur. Dans ce cas, avant injection dudit agent précipitant, l'espace intérieur dudit premier récipient est simplement rempli d'une ambiance gazeuse, neutre du point de vue de la cristallisation.

Toutefois, le procédé conforme à l'invention peut être mis en oeuvre selon le mode dialyse. Alors, avant injection dudit agent précipitant, l'espace intérieur dudit premier récipient est complètement rempli d'agent précipitant à une concentration insuffisante pour engendrer la cristallisation de ladite substance du creuset, et ledit corps poreux dudit second récipient est imbibé d'agent précipitant, également à une concentration insuffisante pour engendrer la cristallisation de ladite substance.

Notamment dans ce dernier cas, afin d'éviter d'emprisonner de l'air entre ledit bouchon de matière poreuse et ledit corps au moment de leur mise en contact, il est avantageux que au moins ledit corps poreux soit spongieux pour être comprimé dès son entrée en contact avec ledit bouchon de matière poreuse.

Par ailleurs, afin de donner plus de souplesse aux expériences de cristallisation, il est préférable que l'on puisse injecter dans ledit corps poreux des concentrations différentes d'agent précipitant.

La présente invention concerne de plus une cellule de cristallogénèse par diffusion, comportant un creuset dans lequel est contenue une substance à cristalliser et qui est obturé par une paroi de diffusion, ledit creuset étant disposé dans une enceinte susceptible de contenir un agent précipitant. Selon l'invention, cette cellule est caractérisée en ce qu'elle comporte :

- un premier récipient dans lequel est agencé ledit creuset et qui est obturé par un bouchon de matière poreuse : et

- un second récipient ouvert contenant un corps poreux et pourvu de moyens d'amenée d'agent précipitant, disposés du côté opposé à l'ouverture dudit second récipient par rapport audit corps poreux.

De préférence, ledit premier récipient peut s'emboîter de façon étanche dans ledit second récipient.

Dans un mode de réalisation avantageux, la face extérieure dudit corps poreux fait saillie à l'extérieur dudit second récipient, ledit corps poreux étant spongieux.

Dans ce cas, il est alors préférable que la partie saillante dudit corps poreux spongieux soit entourée par une bague coulissant à l'intérieur dudit second récipient. Ainsi, lors de l'accostage des premier et seond récipients, ladite bague est repoussée vers l'intérieur dudit second récipient.

Grâce à la présente invention, on peut donc réaliser une installation de cristallogénèse, comportant au moins une cellule du type spécifié ci-dessus et remarquable en ce qu'elle comporte :

- une partie fixe comprenant lesdits seconds récipients, au moins une source d'injection d'agent précipitant reliée auxdits moyens d'amenée, et un réservoir de trop-plein relié à ladite cellule ; et

- une partie amovible comprenant lesdits premiers récipients, dans chacun desquels est agencé un creuset obturé par une paroi de diffusion.

Les figures du dessin annexé feront bien comprendre comment l'invention peut être réalisée. Sur ces figures, des références identiques désignent des éléments semblables.

La figure 1 est une vue en coupe du premier récipient d'un exemple de réalisation de la cellule de cristallogénèse conforme à la présente invention.

La figure 2 est une vue en coupe du second récipient d'un exemple de réalisation de la cellule de cristallogénèse conforme à la présente invention.

La figure 3 illustre l'accostage des premier et second récipients des figures 1 et 2.

La figure 4 illustre la solidarisation desdits premier et second récipients.

Les figures 5 et 6 illustrent une installation de cristallogénèse conforme à la présente invention, respectivement avant et après mise en place desdits premiers récipients.

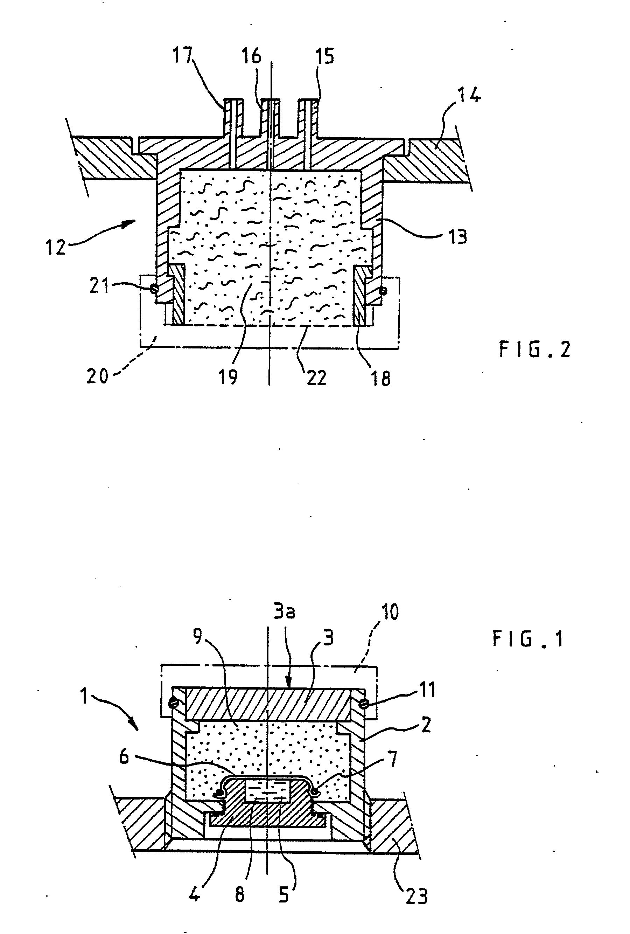

Les modes de réalisation représentés sur les figures 1 à 6 sont particulièrement destinés à la cristallogénèse par dialyse.

Comme on peut le voir sur la figure 1, le premier récipient 1 de cellule de cristallogénèse représenté comporte un corps creux 2, par exemple cylindrique, dont l'ouverture est obturée par un bouchon 3 de matière poreuse mouillante, par exemple de verre fritté dont la face extérieure 3a est par exemple plane. Dans le fond du corps creux 2 est fixé, par exemple par vissage dans une ouverture dudit fond, un creuset 4 en une matière transparente (par exemple en un méthacrylate). La cavité 5 du creuset 4 est obturée par une membrane de diffusion 6, par exemple maintenue par un anneau de serrage 7. Cette cavité 5 est remplie d'un mélange liquide 8 d'une substance à cristalliser et d'un agent précipitant, en concentration insuffisante pour être actif. Par ailleurs, l'espace intérieur du corps 2, entre le creuset 4 et le bouchon poreux 3 est rempli d'agent précipitant 9, dont la concentration est également inférieure au seuil de cristallisation.

Le récipient 1 est fermé par un capuchon 10 (non mouillant) recouvrant le bouchon poreux 3, un joint 11 assurant l'étanchéité entre ledit capuchon 10 et la paroi extérieure du corps creux 2.

Le second récipient 12 de la cellule de cristallogénèse selon l'invention, montré par la figure 2, comporte un corps creux ouvert 13, par exemple cylindrique, dont le diamètre intérieur est légèrement supérieur au diamètre extérieur du corps creux 2 du premier récipient 1.

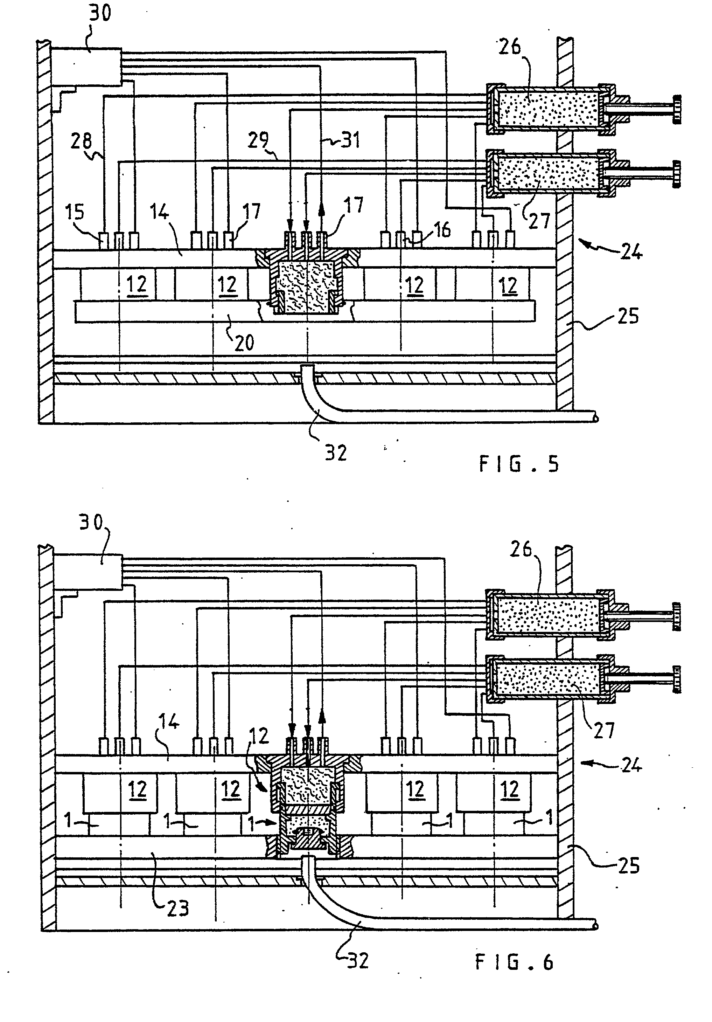

Le corps creux 13 est fixé, par tout moyen connu, à un support 14 et est relié, par exemple par des embouts 15,16 et 17 traversant son fond, à deux sources d'agent précipitant de concentrations différentes et à un réservoir de trop-plein. (Ces sources et réservoir sont visibles sur les figures 5 et 6, où ils portent les références 26,27 et 30).

Du côté de son ouverture, le corps creux 13 est muni d'une bague coulissante intérieure 18, faisant saillie vers l'extérieur et empêchée de se détacher dudit corps creux 13. L'espace intérieur du récipient 12 (y compris la partie saillante de la bague coulissante 18) est rempli d'un tampon de fibers 19 en une matière très mouillante, par exemple de la laine de roche, imbibé de l'agent précipitant en une concentration le rendant inactif. Un capuchon 20, en une matière non mouillante et associé à un joint 21, obture de façon étanche l'extrémité ouverte du corps creux 13 et de la bague coulissante 18. Une grille 22, obture la bague 18 du côté extérieur et sert à retenir le tampon 19 en lui conférant, par exemple, une face extérieure plane.

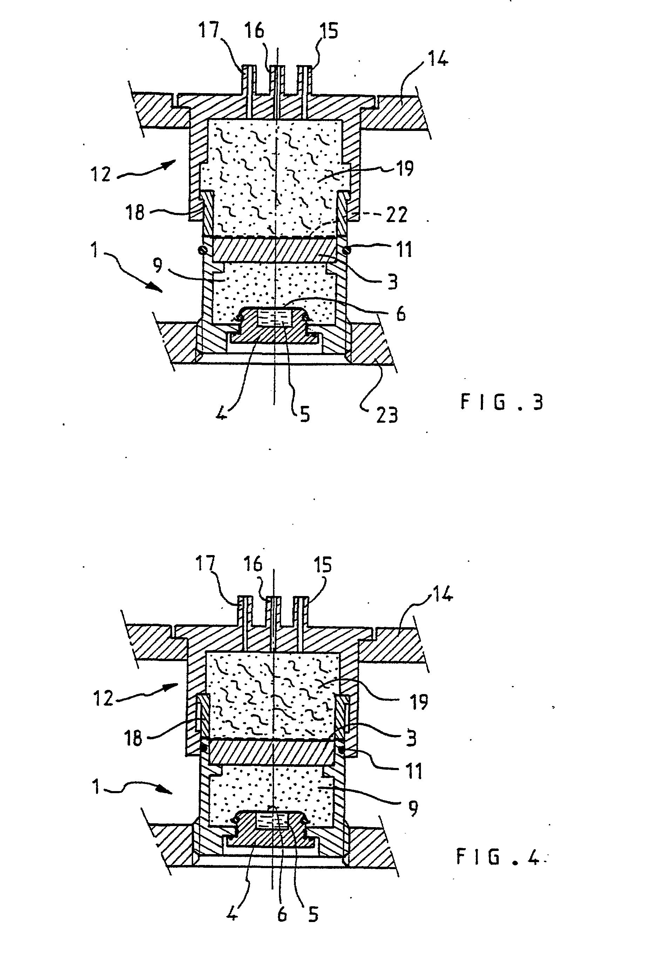

Pour constituer la cellule de cristallogénèse conforme à l'invention, on commence par ôter les capuchons 10 et 20 et l'on rapproche les récipients 1 et 12 (voir la figure 3), jusqu'à ce que le bord du récipient 2 entourant le bouchon poreux 3 soit au contact de la bague coulissante 18. Pour faciliter ce mouvement de rapprochement, le récipient 1 peut être solidarisé d'un support 23.

Dans cette position d'accostage représentée sur la figure 3, le tampon 19 (et sa grille 22) est au contact du bouchon poreux 3 et, la face extérieur 3a de celui-ci et ladite grille 22 étant planes, il n'y a pas d'air emprisonné entre le tampon 19 et le bouchon poreux 3.

Ensuite, le mouvement de rapprochement des récipients 1 et 12 est poursuivi, jusqu'à ce que le récipient 1 pénètre partiellement dans le récipient 12 en repoussant la bague coulissante 18 et en comprimant le tampon 19, de sorte que du liquide est chassé vers le trop-plein 30 et qu'il n'y a aucun risque à ce que de l'air reste emprisonné entre le bouchon 3 et la face 22 du tampon 19. En position de recul extrême de la bague 18 (voir la figure 4), le joint 11 coopère avec la paroi intérieure du corps 13 pour assurer l'étanchéité vis-à-vis de l'extérieur.

Comme le montrent les figures 5 et 6, une installation de cristallogénèse 24 conforme à l'invention peut comporter une pluralité de cellules 1-12 du type décrit en regard des figures 1 à 4. Une telle installation 24 comporte une partie fixe montrée par la figure 5, qui peut être montée à n'importe quel moment opportun à l'intérieur d'un vaisseau spatial, même longtemps avant le lancement de celle-ci.

La partie fixe de l'installation de cristallogénèse 24, montrée par la figure 5, comporte un bâti 25 duquel est solidaire un support commun 14 portant une pluralité de récipients 12, obturés en commun par un capuchon multiple 20. Le bâti 25 porte de plus deux seringues 26 et 27 contenant de l'agent précipitant à des concentrations différentes. La seringue 26 est reliée aux embouts 15 des récipients 12 par des conduits 28, tandis que la seringue 27 est reliée aux embouts 16 desdits récipients 12 par des conduits 29. Un réservoir de trop-plein 30, solidaire du bâti 25, est relié aux embouts 17 des récipients 12 par des conduites 31. Enfin, des fibers optiques 32 sont disposées en regard des ouvertures des récipients 12.

Sur la figure 5 (ainsi que sur les figures 2,3 et 4), les récipients 12 sont représentés avec leur ouverture dirigée vers le bas, mais cette disposition n'est pas essentielle pour la mise en oeuvre de l'invention à bord d'un vaisseau spatial.

La partie amovible de l'installation 24 est essentiellement constituée d'un support 23, portant une pluralité de récipients 1 et pouvant être fixé (de toute manière connue et non-représentée) sur le bâti 25, de façon que chaque récipient 1 puisse se trouver en regard d'un récipient 12 et pénétrer à l'intérieur de celui-ci pour prendre la position illustrée par la figure 4. Cette partie mobile 1-23 n'est montée sur le bâti 25 que peu de temps avant de commencer les expériences.

Ainsi, en attente d'expérience, l'installation 24 se trouve dans la position montrée par le figure 5. Lorsque l'on désire commencer une opération de cristallogénèse, on met en place dans l'installation 24 la partie amovible 1-23, puis, après avoir retiré les capuchons 10 et 20 sans entraîner de liquide avec eux, on rapproche les supports 14 et 23, jusqu'à ce que chaque couple de récipients 1-12 se trouve dans la position de la figure 4, également représentée sur la figure 6. Ensuite, en agissant sur l'une ou l'autre des seringues 26 et 27, ou sur les deux, on injecte l'agent précipitant dans les récipients 12 et 1. La formation des éventuels cristaux ainsi que ceux-ci sont observés à travers les fonds des creusets 4 par les fibres optiques 32, qui conduisent à un appareil optique ou électro-optique (non représenté). L'excès d'agent précipitant est conduit dans le réservoir de trop-plein 30 par les conduites 31.

On remarquera que l'agent précipitant injecté n'atteint les membranes de diffusion 6 qu'après avoir traversé les tampons 19 des récipients 12 et les bouchons poreux 3 des récipients 1. Par suite, le front de diffusion s'étend sur une large surface, de sorte que les conditions de formation des cristaux sont optimales. Il en résulte des cristaux d'excellente qualité.

**Revendications**

1. Procédé de cristallogénèse par diffusion, notamment destiné à être mis en œuvre à bord d'un vaisseau spatial et selon lequel une substance à cristalliser (5), contenue dans un creuset (4), est mise en présence d'un agent précipitant (9) à travers une paroi de diffusion (6) obturant ledit creuset, caractérisé:
   – en ce que, dans un premier récipient (1), on agence ledit creuset contenant la substance à cristalliser et obturé par ladite paroi de diffusion (6);
   – en ce que l'on obture ledit premier récipient (1) par un bouchon (3) de matière poreuse, susceptible d'être protégé par un premier capuchon (10) d'obturation dudit premier récipient (1);
   – en ce que, dans un second récipient (12), on agence un corps poreux (19), susceptible d'être protégé par un second capuchon (20) d'obturation dudit second récipient, ce dernier étant en liaison avec des moyens d'injection d'agent précipitant;
   – en ce que, lesdits premier et second capuchons étant ôtés, on rapproche lesdits premier et second récipients (1 et 12) de façon que ledit corps poreux (19) et ledit bouchon de matière poreuse (3) soient au contact l'un de l'autre; et
   – en ce que l'on injecte l'agent précipitant dans ledit corps poreux (19) dudit second récipient (12), ledit agent précipitant diffusant à travers ledit corps poreux jusqu'à ladite paroi de diffusion (6).

2. Procédé de cristallogénèse selon la revendication 1, du type à diffusion en phase gazeuse, caractérisé en ce que, avant injection dudit agent précipitant, l'espace intérieur dudit premier récipient (1) est rempli d'une ambiance gazeuse, neutre du point de vue de la cristallisation.

3. Procédé de cristallogénèse selon la revendication 1, du type dialyse, caractérisé:
   – en ce que, avant injection dudit agent précipitant, l'espace intérieur dudit premier récipient (1) est complètement rempli d'agent précipitant (9) à une concentration insuffisante pour engendrer la cristallisation de ladite substance (5) du creuset; et
   – en ce que ledit corps poreux (19) dudit second récipient est imbibé d'agent précipitant, également à une concentration insuffisante pour engendrer la cristallisation de ladite substance.

4. Procédé de cristallogénèse selon l'une quelconque des revendications 1 à 3, caractérisé en ce que au moins ledit corps poreux (19) est spongieux pour être comprimé dès son entrée en contact avec ledit bouchon de matière poreuse.

5. Procédé de cristallogénèse selon l'une quelconque des revendications précédentes, caractérisé en ce que l'on peut injecter dans ledit corps poreux des concentrations différentes d'agent précipitant.

6. Cellule de cristallogénèse par diffusion, comportant un creuset dans lequel est contenue une substance à cristalliser et qui est obturé par une paroi de diffusion, ledit creuset étant disposé dans une enceinte susceptible de contenir un agent précipitant, caractérisée en ce qu'elle comporte:
   – un premier récipient (1) dans lequel est agencé ledit creuset (4) et qui est obturé par un bouchon de matière poreuse (3), susceptible d'être protégé par un premier capuchon (10) d'obturation dudit premier récipient (1); et
   – un second récipient ouvert (12) contenant un corps poreux (19) susceptible d'être protégé par un second capuchon (20) d'obturation dudit second récipient et pourvu de moyens d'amenée (15, 16) d'agent précipitant, disposés du côté opposé à l'ouverture dudit second récipient par rapport audit corps poreux.

7. Cellule de cristallogénèse selon la revendication 6, caractérisée en ce que ledit premier récipient (1) peut s'emboîter de façon étanche dans ledit second récipient (12).

8. Cellule de cristallogénèse selon l'une des revendications 6 ou 7, caractérisée en ce que la face extérieure (22) dudit corps poreux fait saillie à l'extérieur dudit second récipient, ledit corps poreux (19) étant spongieux.

9. Cellule de cristallogénèse selon la revendication 8, caractérisée en ce que la partie saillante dudit corps poreux spongieux (19) est entourée par une bague (18) coulissant à l'intérieur dudit second récipient.

10. Installation de cristallogénèse, comportant au moins une cellule du type spécifié sous l'une quelconque des revendications 6 à 9, caractérisée en ce qu'elle comporte:

— une partie fixe comprenant lesdits seconds récipients (12), au moins une source (26, 27) d'injection d'agent précipitant reliée auxdits moyens d'amenée (15, 16), et un réservoir de trop-plein (30) relié à ladite cellule; et

— une partie mobile comprenant lesdits premiers récipients (1), dans chacun desquels est agencé un creuset (4) obturé par une paroi de diffusion (6).

## Patentansprüche

1. Verfahren zum Kristallwachstum durch Diffusion, insbesondere zum Einsatz an Bord eines Raumschiffes, wobei eine zu kristallisierende Substanz (5) in einem Tiegel (4) durch eine den Tiegel abschließende Diffusionswand (6) in Kontakt mit einem Fällungsmittel (9) gebracht wird, dadurch gekennzeichnet,

— daß der die zu kristallisierende Substanz enthaltende und mit der Diffusionswand (6) abgeschlossene Tiegel (4) in einem ersten Gefäß (1) untergebracht ist;

— daß das erste Gefäß (1) mit einem Stopfen (3) aus porösem Material abgeschlossen ist, wobei dieser durch eine erste Verschlußkappe (10) des Gefäßes (1) geschützt werden kann;

— daß ein poröser Körper (19) in einem zweiten Gefäß (12) untergebracht ist, wobei dieser durch eine zweite Verschlußklappe (20) des zweiten Gefäßes (12) geschützt werden kann und wobei das zweite Gefäß (12) in Verbindung mit Einspritzmitteln für das Fällungsmittel (9) steht;

— daß nach Entfernen der ersten und der zweiten Kappe (10, 20) das erste und das zweite Gefäß (1, 12) derart zueinander angenähert werden, daß der poröse Körper (19) und der Stopfen (3) aus porösem Material miteinander in Kontakt kommen; und

— daß das Fällungsmittel (9) in den porösen Körper (19) des zweiten Gefäßes (12) eingespritzt wird, wobei das Fällungsmittel (9) durch den porösen Körper (19) bis zur Diffusionswand (6) diffundiert.

2. Verfahren zum Kristallwachstum durch Diffusion in der Gasphase nach Anspruch 1, dadurch gekennzeichnet, daß vor dem Einspritzen des Fällungsmittels (9) der Innenraum des ersten Gefäßes (1) mit einem in Hinsicht auf die Kristallisation neutralen Gas gefüllt wird.

3. Verfahren zum Kristallwachstum durch Dialyse nach Anspruch 1, dadurch gekennzeichnet,

— daß vor dem Einspritzen des Fällungsmittels (9) der Innenraum des ersten Gefäßes (1) vollständig mit Fällungsmittel (9) in einer zum Auslösen der Kristallisation der Substanz (5) des Tiegels nicht ausreichenden Konzentration gefüllt wird; und

— daß der poröse Körper (19) des zweiten Gefäßes (12) mit Fällungsmittel (9) getränkt ist, ebenso in einer zum Auslösen der Kristallisation der Substanz nicht ausreichenden Konzentration.

4. Verfahren zum Kristallwachstum nach einem der Ansprüche 1 bis 3, dadurch gekennzeichnet, daß wenigstens der poröse Körper (19) schwammartig ausgebildet ist, um nach Kontakt mit dem Stopfen (3) aus porösem Material zusammengedrückt zu werden.

5. Verfahren zum Kristallwachstum nach einem der vorhergehenden Ansprüche, dadurch gekennzeichnet, daß in den porösen Körper (19) unterschiedliche Konzentrationen des Fällungsmittels (9) eingespritzt werden können.

6. Zelle zum Kristallwachstum durch Diffusion mit einem Tiegel, in dem sich eine zu kristallisierende Substanz befindet und der mit einer Diffusionswand abgeschlossen ist, wobei der Tiegel in einer Einfassung angeordnet ist, die ein Fällungsmittel aufnehmen kann, dadurch gekennzeichnet, daß sie aufweist:

— ein erste Gefäß (1), in dem der Tiegel (4) angeordnet ist und das mit einem Stopfen (3) aus porösem Material abgeschlossen ist, wobei dieser durch eine erste Verschlußkappe (10) des Gefäßes (1) geschützt werden kann; und

— ein zweites, offenes Gefäß (12) mit einem porösen Körper (19), wobei dieser durch eine zweite Verschlußkappe (20) des zweiten Gefäßes (12) geschützt werden kann und mit Zuführmitteln (15, 16) für das Fällungsmittel (9) versehen ist, die bezüglich des porösen Körpers (19) auf der der Öffnung des zweiten Gefäßes (12) entgegengesetzten Seite angeordnet sind.

7. Zelle zum Kristallwachstum nach Anspruch 6, dadurch gekennzeichnet, daß das erste Gefäß (1) in abdichtender Weise im zweiten Gefäß (12) aufgenommen werden kann.

8. Zelle zum Kristallwachstum nach einem der Ansprüche 6 oder 7, dadurch gekennzeichnet, daß die Außenseite (22) des porösen Körpers (19) nach außen aus dem zweiten Geäß (12) überseht, wobei der poröse Körper (19) schwammartig ausgebildet ist.

9. Zelle zum Kristallwachstum nach Anspruch 8, dadurch gekennzeichnet, daß der überstehende Teil des schwammartigen porösen Körpers (19) von einem ins Innere des zweiten Gefäßes (12) verschiebbaren Ring (18) umgeben ist.

10. Anlage zum Kristallwachstum mit wenigstens einer Zelle nach einem der Ansprüche 6 bis 9, dadurch gekennzeichnet, daß sie aufweist:

— einen festen Teil mit den zweiten Gefäßen (12), mindestens einer mit den Zuführmitteln (15, 16) verbundenen Einspritzquelle (26, 27) für das Fällungsmittel (9) sowie einem mit der Zelle verbundenen Überlaufgefäß (30); und

— einen beweglichen Teil mit den ersten Gefäßen (1), in denen je ein mit einer Diffusionswand (6) abgeschlossener Tiegel (4) angeordnet ist.

## Claims

1. Process of crystal growth by diffusion, particularly intended to be carried out on board a space vessel and according to which a substance (5) to be crystallized, contained in a crucible (4), is brought into presence with a precipitating agent (9) through a diffusion wall (6) obturating said crucible, characterized:

– in that, in a first recipient (1) is arranged said crucible containing the substance to be crystallized and obturated by said diffusion wall (6);

– in that said first recipient (1) is obturated by a stopper (3) of porous material, capable of being protected by a first obturation cap (10) of said first recipient (1);

– in that, in a second recipient (12) is arranged a porous body (19), capable of being protected by a second obturation cap (20) of said second recipient, the latter being connected with means for injecting precipitating agent;

– in that, said first and second caps being removed, said first and second recipients (1 and 12) are brought together so that said porous body (19) and said stopper of porous material (3) are in contact with each other; and

– in that said precipitating agent is injected into said porous body (19) of said second recipient (12), said precipitating agent diffusing through said porous body up to said diffusion wall (6).

2. Process of crystal growth according to claim 1, of the type with diffusion in vapour phase, characterized in that, before injection of said precipitating agent, the space inside said first recipient (1) is filled with a gaseous medium, neutral from the standpoint of crystallization.

3. Process of crystal growth according to claim 1, of the dialysis type, characterized:

– in that, before injection of said precipitating agent, the space inside said first recipient (1) is completely filled with precipitating agent (9) at a concentration insufficient to generate crystallization of said substance (5) in the crucible, and

– in that said porous body (19) of said second recipient is imbibed with precipitating agent, likewise at a concentration insufficient to generate crystallization of said substance.

4. Process of crystal growth according to any one of claims 1 to 3, characterized in that at least said porous body (19) is spongy in order to be compressed as soon as it comes into contact with said stopper of porous material.

5. Process of crystal growth according to any one of the preceding claims, characterized in that different concentrations of precipitating agent can be injected into said porous body.

6. Cell for crystal growth by diffusion, comprising a crucible in which is contained a substance to be crystallized and which is obturated by a diffusion wall, said crucible being disposed in an enclosure capable of containing precipitating agent, characterized in that it comprises:

– a first recipient (1) in which is arranged said crucible (4) and which is obturated by a stopper (3) of porous material, capable of being protected by a first obturation cap (10) of said first recipient (1); and

– a second open recipient (12) containing a porous body (19) capable of being protected by a second obturation cap (20) of said second recipient and provided with means (15, 16) for conducting precipitating agent, disposed on the side opposite the opening of said second recipient with respect to said porous body.

7. Cell for crystal growth according to claim 6, characterized in that said first recipient (1) may fit in tight manner in said second recipient (12).

8. Cell for crystal growth according to one of claims 6 or 7, characterized in that the outer face (22) of said porous body projects outside said second recipient, said porous body (19) being spongy.

9. Cell for crystal growth according to claim 8, characterized in that the projecting part of said spongy porous body (19) is surrounded by a ring (18) sliding inside said second recipient.

10. Installation for crystal growth, comprising at least one cell of the type specified in any one of claims 6 to 9, characterised in that it comprises:

– a fixed part comprising said second recipients (12), at least one source (26, 27) of injection of precipitating agent connected to said conducting means (15, 16), and an overflow reservoir (30) connected to said cell; and

– a movable part comprising said first recipients (1), in each of which is arranged a crucible (4) obturated by a diffusion wall (6).

17  16  15

14

12

13

21

20  19  22  18

FIG.2

3a  10

9  3

FIG.1

1  11

6  2  7

4  8  5  23

FIG.3

FIG.4

FIG. 5

FIG. 6